# EUROPEAN PATENT APPLICATION

(11) **EP 2 190 032 A1**
(43) Date of publication of application: **26.05.2010**
(21) Application number: 08169899.5
(22) Date of filing: 25.11.2008
(51) Int. Cl.: H01L 31/048

(54) **Photovoltaic fibre reinforced cement panel**

(71) Applicant: REDCO S.A., 1880 Kapelle-op-den-Bos. (BE)
(72) Inventor: Kalbskopf, Reinhard, 1880, Kapelle-op-den-Bos (BE); Mrs Veerle, Deblauwe, 1880 Kapelle-op-de-Bos (BE)
(74) Representative: Vandeberg, Marie-Paule L.G.

(57) **Abstract**

The present invention relates to a photovoltaic assembly comprising a fibre reinforced cement panel (1) and a photovoltaic module (2) comprising a photovoltaic layer (3) wherein the surface of the fibre reinforced cement panel (1) contacting the photovoltaic module (2) is provided with a coating (4). Preferably the photovoltaic assembly comprises an adhesive layer (5) between the photovoltaic module (2) and the coating (4), a transparent layer (7) contacting the upper surface of the photovoltaic module (2) and an adhesive layer (6) between the transparent layer (7) and the photovoltaic module (2).

A process for the production of the photovoltaic assembly and the use of it for wall cladding and roofing applications are also claimed.

## Description

### TECHNICAL FIELD

The present invention relates to a photovoltaic fibre reinforced cement panel. It concerns more particularly a photovoltaic assembly comprising a fibre reinforced cement panel and a photovoltaic module that comprises a photovoltaic layer, wherein the fibre reinforced cement panel is not in direct contact with the photovoltaic module.

The present invention also provides a process for the manufacturing of said fibre reinforced panel, and the use of said fibre reinforced panel in wall cladding and roofing applications.

### PRIOR ART

WO2008/079436 describes solar panels for generating electrical energy and relates more particularly to photovoltaic modules integrated into a laminated sandwich for installation on flat roofs, comprising a frame around its perimeter and a layer of double stick tape on its bottom to adhere it to the surface of a roof. However, the installation of such solar panels is delicate and requires a clean surface. Moreover, there is a risk of water penetration at the interface. Further the building codes in most countries do not allow such fixation systems on façades, particularly high rise façades.

US2001 0054437 concerns a solar cell module especially designed so as to avoid the intrusion of moisture. It includes a substrate and can be integrated with a roofing or walling member. This document does not describe a solar cell module directly laminated on a roof or façade element. Also, the solar cell module described in US20010054437 comprises a profiled substrate, and hence its installation requires especially designed engaging members.

WO2008099975 provides magnesia boards laminated with photovoltaic modules which are covered by a front glass plate. The latter is used for protection of the photoactive cells against mechanical and weathering influences; however it adds considerable weight to the panel, which in turn necessitates stable and expensive holding constructions. Moreover, WO2008099975 does not tackle the problem of possible damage of the adhesive layer which is in direct contact with the magnesia board and is consequently liable to attack by alkali, water or other corrosive ions present in the board matrix.

Accordingly, there is still a need for a lightweight and durable photovoltaic fibre reinforced cement panel. It would further be desirable to provide a photovoltaic fibre reinforced cement panel whose installation does not require special techniques or measures.

### BRIEF DESCRIPTION OF THE DRAWINGS

The invention will be explained in detail below, referring to the accompanying drawings in which :

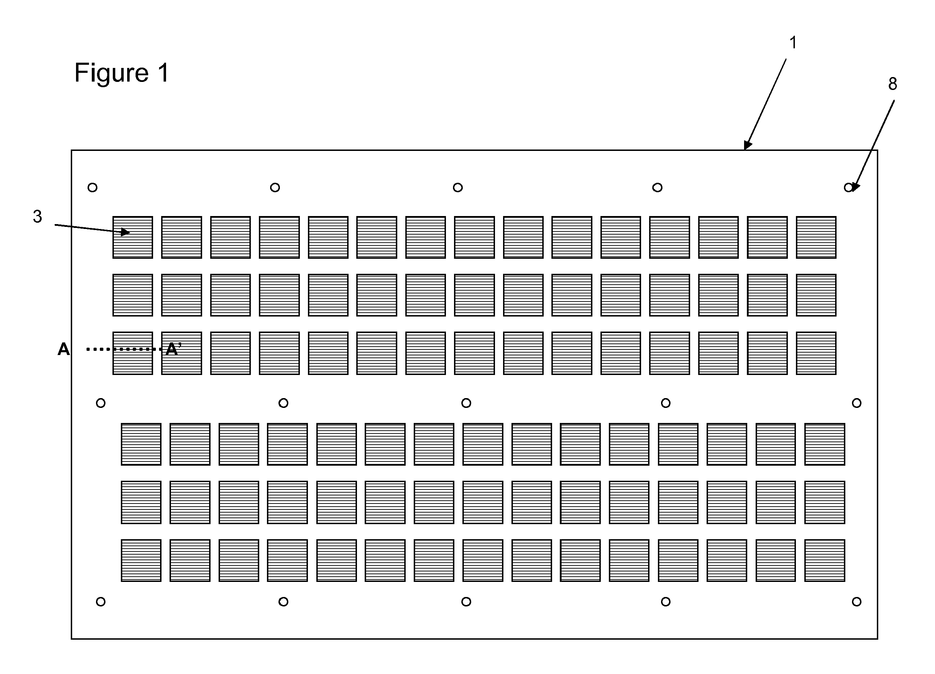

Figure 1 illustrates a schematic top view of a particular embodiment of the photovoltaic assembly.
Figure 2 is a schematic cross-section view of a particular embodiment of the invention taken along the lines A-A' in figure 1.

The figures are not drawn to scale.

### SUMMARY OF THE INVENTION

The present invention provides a photovoltaic assembly comprising a fibre reinforced cement panel (1) and a photovoltaic module (2) which overcomes the disadvantages of the existing assemblies. It solves more specifically the problem of the intrusion of alkali, corrosive ions, aggressive ions or water into the interior of the photovoltaic module (2) by the presence of a coating (4) on the surface of the fibre reinforced cement panel contacting the photovoltaic module (2).

Other aspects of the present invention are a process for the manufacturing of said photovoltaic assembly and the use of said photovoltaic assemblies in wall cladding and roofing applications.

Fibre reinforced cement panels (1) are manufactured starting from an aqueous hydraulic-setting suspension comprising one or more cementitious binders, processing fibres, and optionally reinforcing fibres, processing aids, additives and/or fillers. This aqueous suspension has a solid content generally ranging from 2 to 10% and is mixed so as to obtain a substantially uniform distribution of the components. The suspension is then dewatered, and the fresh product (green product) is shaped in the form of a plane sheet, which is optionally post-compressed to densify and subsequently left to harden under atmospheric conditions (air-curing) or under pressurized steam at a temperature above 100°C (autoclaving).

The hydraulic-setting composition used for the manufacture of the fibre reinforced cement panel (1) comprises cement as hydraulic binder. Suitable cements are Portland cement, high-alumina cement, blast-furnace Portland cement, trass cement, slag cement, and others. Portland cement is preferred. The highly alkaline character of these hydraulic binders is well-known.

The hydraulic-setting composition used for the manufacture of the fibre reinforced cement panel (1) possibly comprises reinforcing organic and/or inorganic fibers.

Examples of reinforcing inorganic fibres are glass fibres, ceramic fibres, wollastonite fibres and the like, and their blends. Examples of organic reinforcing fibres are fibres of cellulose, of polyolefins such as polyethylene or polypropylene, of polyamide, of polyacrylonitrile, of polyester, of aramid, of polyvinylalcohol, of carbon, and the like, and their blends. The content of reinforcing fibres is preferably equal to or less than 10% by weight with respect to the initial total weight in the dry state of the hydraulic-setting composition.

The hydraulic-setting composition used for the manufacture of the fibre reinforced cement panel (1) comprises processing aids, such as processing fibres, flocculants, anti-foam agents. Appropriate processing fibres are cellulose fibres, polyolefin fibrils, and others, and their blends. The amount of processing fibres is preferably equal to or less than 10% by weight with respect to the initial total weight in the dry state of the hydraulic-setting composition.

The hydraulic-setting composition used for the manufacture of the fibre reinforced cement panel (1) may further comprise fillers and/or additives, such as fly ash, amorphous silica, ground quartz, ground rock, clays, blast-furnace slags, carbonates, pozzolana, etc. The total quantity of fillers and/or additives is preferably less than 50% by weight with respect to the initial total weight in the dry state of the hydraulic-setting composition.

The process for the manufacture of the fibre reinforced cement panel (1) most widely used is the Hatschek process, which is a modified sieve cylinder paper making machine. Other manufacturing processes are the Magnani process, injection, extrusion, flow-on and others. The fibre reinforced cement panels used in the photovoltaic assembly according to the present invention are preferably manufactured by the Hatschek process.

The photovoltaic assembly includes a photovoltaic module (2). The latter comprises a photovoltaic layer (3) comprising a plurality of solar cells arranged in an array of rows and columns, and all the electrical connections. The photovoltaic cells are electrically interconnected in a series-parallel configuration in a conventional manner to provide a suitable output voltage. Preferably, several arrays of solar cells are positioned as strips in a manner to leave areas to allow drilling of holes (8) for fixing the fibre reinforced cement panel to the wall or roof.

The solar cells may comprise without being limited to, mono- or poly-crystalline silicon, amorphous silicon or a semiconductor alloy such as CIS (copper-indium selenide CuInSe₂), CIGS (copper indium/gallium diselenide CuInₓGa₍₁₋ₓ₎Se₂). Preferably, the solar cells comprise crystalline or amorphous silicon because semi-conductor alloys have lower chemical resistance and should preferably be used with a protective glass layer. Solar cells comprising mono- or poly-crystalline silicon wafers are particularly preferred as their photo-electricity generating efficiency is higher compared to photovoltaic cells based on thin films of amorphous silicon.

The fibre reinforced cement panel (1) is provided on its surface contacting the photovoltaic module (2) with a coating (4) so as to avoid direct contact between the fibre reinforced cement panel (1) and the photovoltaic module (2). In such embodiment of present invention, the photovoltaic assembly is comprising a fibre reinforced cement panel (1) and a photovoltaic module (2) that comprises a photovoltaic layer (3), wherein the surface of the fibre reinforced cement panel (1) contacting the photovoltaic module (2) is provided with a coating (4).

Preferably the coating (4) comprises at least one layer selected among acrylic, radiation curable, electron-beam curable or two-component polyurethane coatings. It can comprise a combination of two or more layers : for example, a first layer of an acrylic coating in direct contact with the cement panel and a second layer of a radiation curable coating in direct contact with the first coating layer, whereby the first acrylic coating layer can be coloured and ensures a good adhesion with the fibre reinforced cement panel (1).

The coating (4) avoids direct contact of the photovoltaic module with alkalis, water aggressive or corrosive ions present in the fibre reinforced cement panel. Alkalis are especially present in air-cured (non-autoclaved) fibre reinforced cement products; however, the high alkalinity and the presence of water or aggressive ions typical for all types of fibre reinforced cement panels require, according to present invention, the use of the coating (4).

Preferably, a carbonation reducing coating is applied on the rear side of the fibre reinforced cement panel in order to avoid warping of the fibre reinforced cement panel due to differential carbonation or shrinkage upon drying. Suitable carbonation reducing and water impermeable coatings are selected from the group comprising polyvinylidenechloride, styrene-butadiene rubber, radiation, thermally, air or chemically curable coatings and their mixtures.

Preferably, the photovoltaic assembly according to the present invention comprises a transparent layer (7) contacting the upper surface of the photovoltaic module (2).

This transparent layer (7) protects the photovoltaic module (2) from the ingress of moisture, water and oxygen, and provides impact and scratch protection. The transparent layer (7) preferably comprises a waterproof and chemically resistant resin. Suitable transparent layers are selected among fluorinated ethylene-propylene (FEP) or ethylene-tetrafluoroethylene (ETFE) resins, or their blends. ETFE is particularly preferred as its UV transmittance is higher compared to FEP.

According to a preferred embodiment of the present invention, the photovoltaic assembly comprises an adhesive layer (6) between the transparent layer (7) and the photovoltaic module (2).

In another preferred embodiment of the present invention, the photovoltaic assembly comprises an adhesive layer (5) between the photovoltaic module (2) and the coating (4).

Suitable adhesive layers (5) and (6) are selected independently among heat-activated adhesives such as ethylene-vinyl acetate copolymers (EVA), ethylene-methyl acrylate copolymers (EMA), ethylene-ethyl acrylate copolymers, polyvinyl butyral (PVB) and thermoplastic polyurethanes (TPU), or non-heat activated adhesives such as modified silane polymers. EVA and PVB resins are particularly preferred resins of the adhesives layers (5) or (6). EVA is most suitable but is considered as particularly sensitive to alkali. Current commercially available thermoplastic polyurethanes (TPU) are less appropriate, because they require temperatures close to the decomposition temperature of the cement hydrates, which results in inferior mechanical strength or shrinkage cracks.

The invention also provides a process for the production of a photovoltaic assembly according to the present invention, comprising the following steps :
a) positioning of the photovoltaic modules (2) on the fibre reinforced cement panel (1) which is provided with the coating (4);
b) bonding of the photovoltaic modules (2) on the fibre reinforced cement panel (1) which is provided with the coating (4).

According to a preferred mode of execution of step a) of the process according to the present invention, the adhesive layer (5) is laid down on the coated surface of the fibre reinforced cement panel (1) which is provided with the coating (4). Next, groups of pre-wired solar cells are stacked thereon. Groups of photovoltaic cells are electrically interconnected in order to obtain the photovoltaic module (2), and are then covered by the adhesive layer (6), followed by the transparent layer (7). In order to improve the waterproof integrity , the size of the layers (5), (6) and (7) is larger than the size of the photovoltaic module (2), in order to avoid intrusion of water into the photovoltaic layer (3).

Step b) of the process according to the present invention involves bonding of the photovoltaic modules (2) on the fibre reinforced panel (1) provided with coating (4). Step b) can be performed in various ways. A preferred mode of bonding is lamination such as hot press (hot plate) vacuum lamination or roller lamination. Preference is given to hot plate vacuum lamination, because roller lamination often requires preheating of the adhesive layers (5) and (6).

In order to reduce the required heating time during lamination until the surface temperature necessary for the melting of the adhesive layers (5) and (6), the reverse order can be used as well; a thin rigid support (e.g. a glass plate) is then needed. Several strips, each comprising one or more arrays of interconnected sandwiched solar cells are aligned in the areas located outside the areas provided for the fixation holes (8) in the fibre reinforced cement panel (1). The free ends of the output conductors are covered with a temporary covering and passed through small holes in the adhesive layer (5).

Preferably step b) is performed immediately after application of the coating (4), so that the residual heat of the freshly coated panel can be used to shorten the heating up time.

In a preferred embodiment, EVA is used for the adhesive layers (5) and (6), and bonding is preferably performed in a vacuum plate laminator : the sandwich structure obtained in step (a) of the process is heated to a suitable temperature (e.g. between about 80 and 150°C) which is high enough for the adhesive EVA layers (5) and (6) to melt and cross-link and to fill up the empty spaces between the photovoltaic cells without damaging them, and during a time dependent on the thickness of the fibre reinforced panel (1) and the adhesive layers (5) and (6), for example during 10 to 30 minutes. Once the required temperature for adhesive bonding is achieved on the surface of the assembled sandwich structure, pressure is applied. During the lamination process, the EVA melts and undergoes thermal crosslinking initiated by an organic peroxide; the formation of entrapped air-bubbles is avoided by lamination in vacuum and under mechanical pressure. In case TPU is used for the adhesive layers (5) and (6), continuous roller lamination is preferred, but vacuum lamination is possible as well.

After the laminated structure is allowed to cool to ambient temperature, the temporary coverings over the output connectors are removed and passed through a hole in the fibre reinforced cement panel and connected to a power cable through a junction box glued on the reverse side of the fibre reinforced cement panel.

### DETAILED DESCRIPTION OF PARTICULAR EMBODIMENTS

It will be obvious for a person skilled in the art that the present invention is not limited to what was disclosed and described particularly above. All new characteristics and each combination of these characteristics belong to the scope of the invention. The numerical references in the claims do not limit the scope of their protection. The use of the verbs "to comprise or to include" and their conjugated forms does not exclude the presence of other elements than those cited in the claims. The use of the article "a or an" in front of an element, does not exclude the presence of a plurality of such elements. The invention is described hereafter in a detailed way using particular examples of embodiment.

### EXAMPLES

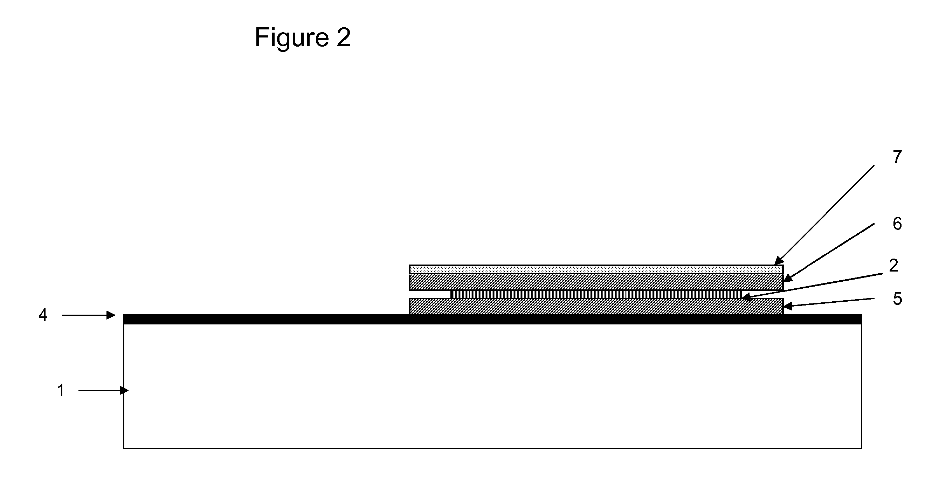

For the example according to the invention, test samples (30 cm x 30 cm) of 8 mm thick fibre reinforced cement panels Eternit Natura^{®} have been laminated immediately after the application of a 50-70 µm thick acrylic coating comprising essentially Primal^{®} SS-521 commercialized by Rohm and Haas, with a photovoltaic module; the latter comprises one crystalline silicon solar cell (15,6 cm x 15,6 cm). A sandwich structure as depicted in figure 2 was obtained. Lamination has been performed in a vacuum laminator equipped with a bottom heating plate; the size of the EVA adhesive layers (5) and (6) and the transparent layer (7) of ethylene-tetrafluoroethylene ETFE was about 18 cm x 18 cm.

Uncoated fibre reinforced cement Eterplan^{®} N test samples (8 mm thickness) of the same size have been used in the comparative example and were provided with the same layers (5), (6) and (7) under similar operating conditions.

Both sets had a PVDC coating on the reverse side of the fibre cement panel.

Table 1 gives an overview of the layers and their thickness.

The lamination parameters are as follows : Plate temperature: 130°C; Time: 15 min; Pressure: 100 kPa; Vacuum: 3 kPa.

**Table 1**

| Layer | Type | Trade name | Thickness (mm) |
|---|---|---|---|
| 7 | ETFE | Tefzel^{®} | 0,05 |
| 5 | EVA | Etimex^{®}Vistasolar^{®} | 0,5 |
| 6 | EVA | Etimex^{®}Vistasolar^{®} | 0,5 |

Both sets were subjected to standard test for fibre cement flat sheets EN 12467 (50 cycles of immersion in water during 18 hrs at 20°C followed by 6 hours in a ventilated oven at 60°C), and visually evaluated afterwards.

The comparative test sample showed a milky and stained aspect, indicating the attack of the adhesive layer 5. The appearance of the test sample according to the invention is unchanged after the test.

## Claims

1. Photovoltaic assembly comprising :
- a fibre reinforced cement panel (1)
- a photovoltaic module (2) comprising a photovoltaic layer (3)
wherein
the surface of the fibre reinforced cement panel (1) contacting the photovoltaic module (2) is provided with a coating (4).

2. Photovoltaic assembly according to claim 1 comprising an adhesive layer (5) between the photovoltaic module (2) and the coating (4).

3. Photovoltaic assembly according to claim 2 wherein the adhesive layer (5) is selected among ethylene-vinyl acetate copolymers (EVA), ethylene-methyl acrylate copolymers (EMA), ethylene-ethyl acrylate copolymers, polyvinyl butyral (PVB) and thermoplastic polyurethanes (TPU).

4. Photovoltaic assembly according to any of the preceding claims comprising a transparent layer (7) contacting the upper surface of the photovoltaic module (2).

5. Photovoltaic assembly according to claim 4 wherein the transparent layer (7) is selected among a fluorinated ethylene-propylene (FEP) ethylene-tetrafluoroethylene (ETFE) resins, or their blends.

6. Photovoltaic assembly according to any of the preceding claims comprising an adhesive layer (6) between the transparent layer (7) and the photovoltaic module (2).

7. Photovoltaic assembly according to claim 6 wherein the adhesive layer (6) is selected among ethylene-vinyl acetate copolymers (EVA), ethylene-methyl acrylate copolymers (EMA), ethylene-ethyl acrylate copolymers, polyvinyl butyral (PVB) and thermoplastic polyurethanes (TPU).

8. Photovoltaic assembly according to any of the preceding claims wherein the coating (4) comprises at least one layer selected among acrylic, radiation curable, electron-beam curable or two-component polyurethane coatings.

9. Process for the production of a photovoltaic assembly according to any of the preceding claims, comprising the following steps :
a) positioning of the photovoltaic modules (2) on the fibre reinforced cement panel (1) provided with the coating (4);
b) bonding of the photovoltaic modules (2) on the fibre reinforced cement panel (1) provided with the coating (4).

10. Process for the production of a photovoltaic assembly according to claim 9 wherein the bonding is made by vacuum lamination.

11. Use of a photovoltaic assembly according to any of the preceding claims for wall cladding and roofing applications.

## Amended claims

### Amended claims in accordance with Rule 137(2) EPC.

**1.** A photovoltaic fibre reinforced cement panel (1) manufactured according to a process selected among the Hatschek or flow-on process comprising:
- a photovoltaic module (2) comprising a photovoltaic layer (3),
- a coating (4) on its surface contacting the photovoltaic module (2),
- an adhesive layer (5) between the photovoltaic module (2) and the coating (4),
- a transparent layer (7) contacting the upper surface of the photovoltaic module (2),
- an adhesive layer (6) between the transparent layer (7) and the photovoltaic module (2),
**characterized in that**
- the coating (4) avoids direct contact of the photovoltaic module (2) with alkalis, water and aggressive ions present in the panel (1),
- the photovoltaic module (2) is roller or vacuum laminated on the surface of the fibre reinforced cement panel (1) provided with the coating (4),
- a carbonation reducing coating is applied on the rear side of the panel (1).

**2.** Photovoltaic fibre reinforced cement panel according to claim 1 wherein the adhesive layer (5) is selected among ethylene-vinyl acetate copolymers (EVA), ethylene-methyl acrylate copolymers (EMA), ethylene-ethyl acrylate copolymers, polyvinyl butyral (PVB) and thermoplastic polyurethanes (TPU).

**3.** Photovoltaic fibre reinforced cement panel according to claim 1 or 2 wherein the transparent layer (7) is selected among a fluorinated ethylene-propylene (FEP) ethylene-tetrafluoroethylene (ETFE) resins, or their blends.

**4.** Photovoltaic fibre reinforced cement panel according to any of the preceding claims wherein the adhesive layer (6) is selected among ethylene-vinyl acetate copolymers (EVA), ethylene-methyl acrylate copolymers (EMA), ethylene-ethyl acrylate copolymers, polyvinyl butyral (PVB) and thermoplastic polyurethanes (TPU).

**5.** Photovoltaic fibre reinforced cement panel according to any of the preceding claims wherein the coating (4) comprises at least one layer selected among acrylic, radiation curable, electron-beam curable or two-component polyurethane coatings.

**6.** Use of a photovoltaic flat fibre reinforced cement panel according to any of the preceding claims for wall cladding and roofing applications.
